(19) Europäisches Patentamt
European Patent Office
Office européen des brevets

(11) **EP 1 514 352 B1**

(12) **FASCICULE DE BREVET EUROPEEN**

(45) Date de publication et mention
de la délivrance du brevet:
**23.02.2011 Bulletin 2011/08**

(21) Numéro de dépôt: **03760738.9**

(22) Date de dépôt: **18.06.2003**

(51) Int Cl.:
***H03L 7/081*** *(2006.01)*

(86) Numéro de dépôt international:
**PCT/FR2003/001858**

(87) Numéro de publication internationale:
**WO 2004/001973 (31.12.2003 Gazette 2004/01)**

(54) **BOUCLE A VERROUILLAGE DE RETARD**

VERZÖGERUNGSVERRIEGELTER KREIS

DELAY-LOCKED LOOP

(84) Etats contractants désignés:
**AT BE BG CH CY CZ DE DK EE ES FI FR GB GR HU IE IT LI LU MC NL PT RO SE SI SK TR**

(30) Priorité: **19.06.2002 FR 0207560**

(43) Date de publication de la demande:
**16.03.2005 Bulletin 2005/11**

(73) Titulaire: **Commissariat à l'Énergie Atomique et aux Énergies Alternatives**
**75015 Paris (FR)**

(72) Inventeur: **MORCHE, Dominique**
**F-38240 Meylan (FR)**

(74) Mandataire: **Poulin, Gérard et al**
**BREVALEX**
**95 rue d'Amsterdam**
**75378 Paris Cedex 8 (FR)**

(56) Documents cités:
WO-A-01/45263        US-A- 5 889 436
US-A- 6 147 525      US-A- 6 154 073

## Description

Domaine technique et art antérieur

L'invention concerne une boucle à verrouillage de retard plus communément appelée boucle DLL (DLL pour

« Delay Locked Loop »).

Les boucles DLL sont communément utilisées pour aligner en phase deux signaux d'horloge, notamment dans les mémoires DRAM (DRAM pour « Dynamic Random Access Memory »). Les boucles DLL permettent alors d'obtenir un très bon synchronisme entre une horloge externe au circuit intégré et une horloge interne. Les boucles DLL sont également utilisées pour générer ou mesurer un retard temporel avec précision, ou encore pour générer des horloges d'échantillonnage de signal (*cf.* « An Eight Channel 36GSample/s CMOS Timing Analyser », Dan Weinlader, Ron Ho, Chih-Kong Ken Yang, Mark Horowitz, 2000 IEEE International Solid-State Circuits Conference).

L'invention s'applique à tous les domaines mentionnés ci-dessus et, de façon plus particulièrement avantageuse, à la génération et à la mesure de retards dans les émetteurs-récepteurs utilisant la technique de communication de type ultra large bande.

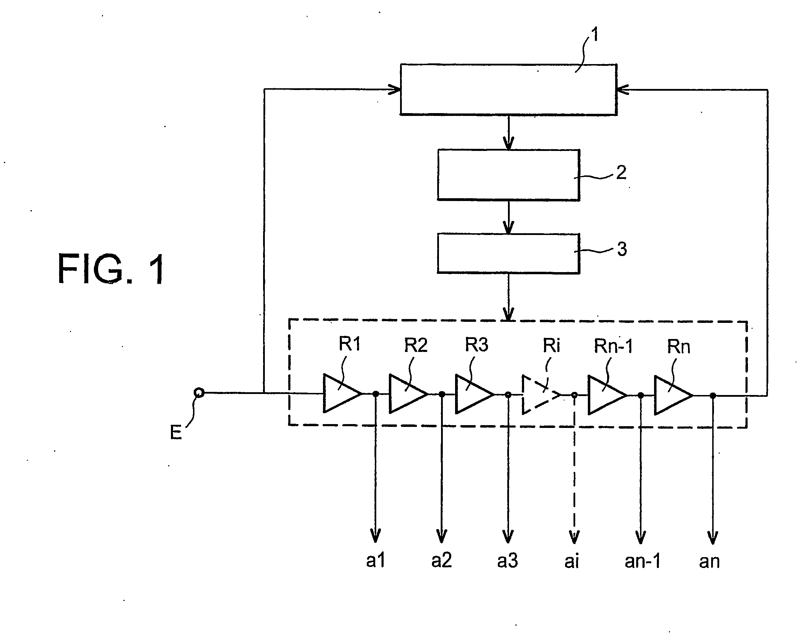

Le schéma de principe d'une boucle DLL selon l'art antérieur est donné en figure 1. La boucle DLL comprend une chaîne de retard composée de n cellules de retard Ri (i=1, 2, 3, ..., n-1, n) en série, d'un détecteur de phase/fréquence 1, d'une pompe de charges 2 et d'un filtre de boucle 3. Chaque cellule de retard introduit un retard $\Delta t$ identique aux retards des autres cellules. Le retard $\Delta t$ peut être contrôlé par un signal qui peut être une tension ou un courant. Chaque cellule de retard peut être réalisée à l'aide d'une paire différentielle. La variation du retard $\Delta t$ est alors obtenue par la variation du courant de polarisation de la paire différentielle.

L'entrée et la sortie de la chaîne de retard sont appliqués au détecteur de phase/fréquence 1. Le détecteur de phase/fréquence 1 peut être un simple comparateur de phase qui compare les phases des signaux d'entrée et de sortie de la chaîne de retard. Le signal issu du détecteur 1 commande la pompe de charge 2 qui génère alors un courant fonction de la différence de phase entre le signal d'entrée et le signal de sortie de la chaîne de retard. Ce courant est appliqué en entrée du filtre de boucle 3 pour être filtré. Le courant filtré issu du filtre de boucle 3 est appliqué aux cellules de la chaîne de retard pour contrôler le retard des cellules.

Le mode de fonctionnement d'une boucle DLL selon l'art connu va maintenant être décrit.

Un signal de période T est appliqué sur l'entrée de la chaîne de retard. Lorsque la boucle DLL est stabilisée, les signaux en entrée et en sortie de la chaîne de retard sont en phase. Le retard entre ces deux signaux est alors égal à T. Puisque toutes les cellules de retard sont identiques, le retard apporté par une cellule est égal à T/n. On dispose alors, en plus du signal d'horloge appliqué en entrée de la chaîne de retard; de n signaux d'horloge ai (i=1, 2, 3, ..., n-1, n), un signal ai étant décalé de l'intervalle de temps iT/n par rapport au signal d'horloge appliqué en entrée de la chaîne de retard. Les différents signaux ai peuvent être utilisés pour mesurer un retard, générer un retard, synthétiser un signal de fréquence, reconstruire des signaux, et..

Un avantage de ce type de structure est la faible consommation. Cependant, plusieurs inconvénients peuvent être soulignés.

Ainsi, générer un retard mT/n peut-il conduire à utiliser un nombre n de cellules élevé. Par exemple, un retard de 13T/100 (m=13 et n=100) nécessite l'utilisation de cent cellules de retard.

Par ailleurs, la structure est limitée en fréquence par le retard minimum Tmin qu'impose chaque cellule de retard élémentaire. Lorsqu'on travaille à fréquence maximale, il n'est en effet pas possible de générer un retard qui ne soit pas un multiple entier de Tmin.

L'invention ne présente pas ces inconvénients.

De l'art antérieur sont également connus le brevet US 6 147 525 et la demande de brevet WO 01/45263.

Le brevet US 6 147 525 divulgue une boucle à verrouillage de retard qui comprend une chaîne de cellules de retard montées en série. Le problème que se propose de résoudre le brevet US 6 147 525 est la réduction du bruit de phase de la boucle à verrouillage de retard. La demande de brevet WO 01/45263 divulgue un système de division/multiplication d'un signal de fréquence de référence.

Exposé de l'invention

En effet l'invention concerne une boucle à verrouillage de retard fractionnaire dans laquelle :

- une chaîne de cellules de retard montées en série a une entrée agencée pour recevoir un signal d'entrée ;

- un détecteur de phase/fréquence a une première entrée connectée à ladite entrée de la chaîne de cellules de retard, une deuxième entrée connectée sélectivement à la sortie de l'une des cellules de retard, et une sortie couplée à ladite chaîne de cellules de retard pour contrôler le retard de la chaîne de cellules de retard ;

- la boucle à verrouillage de retard est agencée pour délivrer un signal de retard fractionnaire prélevé sur la sortie de l'une des cellules de retard ; et

- des moyens de commande sont agencés pour sélectionner, au rythme d'un signal d'horloge et sous l'action d'une information de commande, la sortie de la cellule de retard qui est connectée à la deuxième entrée du détecteur phase/fréquence.

La boucle à verrouillage de retard selon l'invention permet ainsi de modifier le nombre de cellules de retard vu par le détecteur de phase/fréquence. Cette modification permet de produire un retard élémentaire de chaque cellule de retard différent du retard élémentaire T/n obtenu selon l'art antérieur, le retard d'une cellule de retard étant un retard fractionnaire. Il est ainsi possible d'obtenir une boucle DLL fractionnaire.

Une modification du nombre de cellules de retard vues par le détecteur de phase/fréquence peut se faire à chaque coup d'horloge du signal appliqué en entrée de la chaîne de retard. Cette modification peut également se faire à une fréquence plus faible.

L'utilisation d'un nombre de cellules de retard inférieur au nombre total de cellules de retard disponibles présente également l'avantage de réduire la consommation de la boucle DLL. De plus, la fréquence de travail maximum est augmentée puisque cette fréquence maximum est inversement proportionnelle à la quantité NTmin, où N est le nombre de cellules de retard utilisées et Tmin est le délai minimal apporté par une cellule de retard élémentaire.

Brève description des figures

D'autres caractéristiques et avantages de l'invention apparaîtront à la lecture d'un mode de réalisation préférentiel de l'invention fait en référence aux figures jointes parmi lesquelles :

- la figure 1 représente une boucle à verrouillage de retard selon l'art antérieur ;
- la figure 2 représente une boucle à verrouillage de retard selon un premier mode dé réalisation de l'invention ;
- la figure 3 représente un exemple de boucle à verrouillage de retard selon le premier mode de réalisation de l'invention ;
- la figure 4 représente une boucle à verrouillage de retard selon un deuxième mode de réalisation de l'invention ;
- les figure 5A et 5B représentent, respectivement, un perfectionnement de la boucle à verrouillage de retard selon le premier mode de réalisation de l'invention et un perfectionnement de la boucle à verrouillage de retard selon le deuxième mode de réalisation de l'invention.

Sur toutes les figures, les mêmes références désignent les mêmes éléments.

Description détaillée de modes de mise en oeuvre de l'invention

La figure 1 a été décrite précédemment ; il est donc inutile d'y revenir.

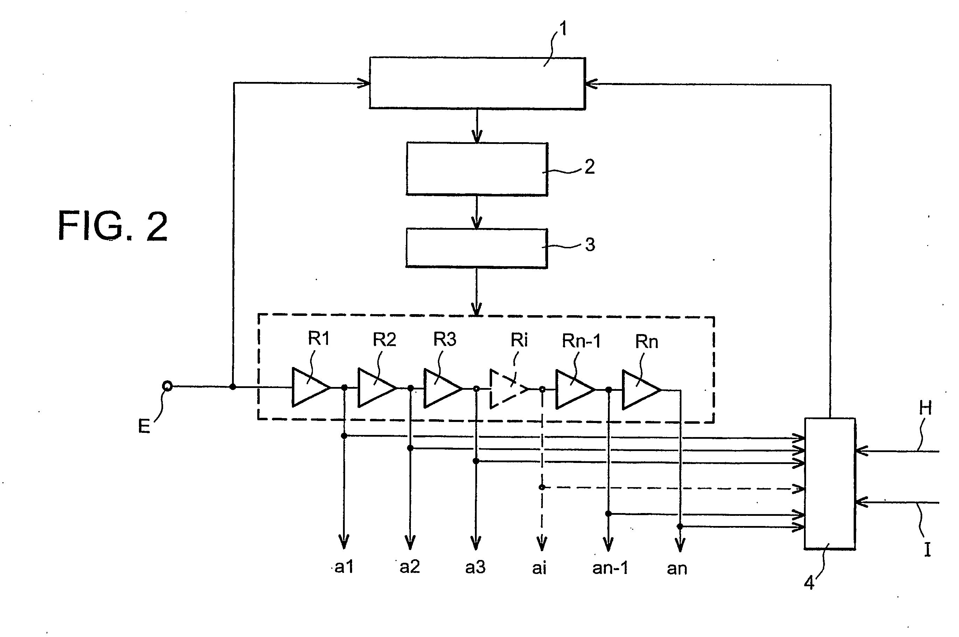

La figure 2 représente une boucle à verrouillage de retard selon un premier mode de réalisation de l'invention.

Outre les éléments déjà mentionnés en description de la figure 1, une boucle DLL selon le premier mode de réalisation de l'invention comprend des moyens de multiplexage 4. Les moyens de multiplexage 4 comprennent n entrées de signal, une sortie de signal, une entrée d'horloge et une entrée de commande.

Chaque entrée de signal des moyens de multiplexage 4 est reliée à un signal retardé ai différent (i=1, 2, ..., n). La sortie de signal est reliée à l'une des entrées du détecteur de phase/fréquence 1. Le signal qui, parmi les signaux appliqués en entrée du multiplexeur, est appliqué sur l'entrée du détecteur de phase/fréquence 1 est déterminé par un signal d'horloge H appliqué sur l'entrée d'horloge et par une information I appliquée sur l'entrée de commande. A chaque coup du signal d'horloge H, le signal appliqué au détecteur de phase/fréquence est choisi en fonction de l'information I. L'information I effectue ainsi la sélection du séquencement des signaux qui sont appliqués, au rythme du signal d'horloge H, en entrée du détecteur de phase/fréquence.

Le signal d'horloge H peut être le même signal que le signal d'horloge appliqué en entrée de la chaîne de retard ou un signal d'horloge différent. L'information I peut être une information périodique ou non périodique.

De façon générale, la modification du nombre de cellules de retard vues par le détecteur de phase/fréquence peut avoir lieu à chaque coup d'horloge du signal d'horloge H ou à une fréquence plus faible. Cette modification peut être mise en oeuvre de telle sorte que la valeur moyenne du nombre de cellules de retard vues par le détecteur de phase/fréquence est choisie à l'avance en fonction du retard fractionnel que l'on cherche à obtenir. A titre d'exemple, la valeur moyenne du nombre de cellules de retard vues par le détecteur peut être obtenue en effectuant une moyenne pondérée et en utilisant comme pondération pour chaque cellule de retard le nombre de coup d'horloge de l'horloge H pendant lequel le nombre de cellules de retard est effectif. Il existe alors une relation entre le nombre moyen de cellules de retard utilisées NC et le retard $\Delta t$ d'une cellule élémentaire, à savoir :

$$\Delta t = T/NC$$

A titre d'illustration des performances d'une boucle DLL selon l'invention, un exemple non limitatif va maintenant être donné. On considère une chaîne de retard qui comprend dix cellules de retard (n=10). On suppose que l'horloge H qui commande le multiplexage est identique, à un retard près, à l'horloge qui est appliquée en entrée de la chaîne de retard. Le signal appliqué au détecteur de phase/fréquence est différent à chaque coup d'.horloge de la fréquence d'entrée. On suppose également, dans cet exemple, que le signal sélectionné par l'information I pour être appliqué en entrée du détecteur de phase/fréquence est une alternance des signaux a10 et a9. La phase moyenne qui est comparée par le détecteur de phase/fréquence est alors égale à 9.5 $\Delta t$, où $\Delta t$ est le retard d'une cellule de retard élémentaire. Il vient donc la relation:

$$\Delta t = 2T/19$$

Il est alors possible de générer des retards égaux à 2T/19, 4T/19,...,18T/19 avec une chaîne de dix retards. Pour obtenir un tel résultat à l'aide une boucle DLL selon l'art antérieur, dix-neuf retards sont nécessaires.

Il va maintenant être décrit comment, de façon plus générale, générer un retard quelconque à partir d'une boucle DLL fractionnaire simple. Par boucle DLL fractionnaire simple, il faut entendre une boucle DLL qui n'utilise, pour le multiplexage, que deux signaux de retard successifs, par exemple les signaux an-1 et an.

On suppose que les signaux an-1 et an sont respectivement utilisés pendant p coups d'horloge et q-p coups d'horloge. La valeur moyenne du retard apporté par la chaîne de retard est alors égale à (n-p/q)$\Delta t$. La valeur du retard d'une cellule élémentaire est alors donnée par la relation :

$$\Delta t = q\ T/(qn-p)$$

A titre d'exemple non limitatif, pour une chaîne de retard comprenant dix cellules de retard et en supposant que I est un signal périodique de période 100T (q=100 et la valeur moyenne d'un retard est alors obtenue sur 100 points), il vient donc:

$$\Delta t = 100T/(1000-p)$$

Une évaluation du nombre p conduit alors à :

$$P = PART[1000-100T/\Delta t]$$

où PART[X] représente la partie entière de X.

Pour réaliser un retard fractionnaire égal à aT/b en sortie de la cellule de retard de rang k, a et b étant deux nombres entiers quelconques, il faut poser :

$$k\ \Delta t = a\ T/b,$$

soit

$$a\ T/b = k\ q\ T/(q\ n-p)$$

Il apparaît donc un système de 2 équations à 4 inconnues p, q, n, k, chaque inconnue étant un nombre entier. Un tel système d'équations a toujours des solutions.

Par exemple, pour réaliser un retard égal à 13T/100, la solution est la suivante :

$$p=4,\ q=13,\ n=8,\ k=1$$

Le retard de 13T/100 est alors obtenu avec seulement huit cellules de retard. Ce résultat est à comparer avec le résultat obtenu selon l'art antérieur où cent cellules de retard sont nécessaires (cf. ci-dessus).

Un autre exemple peut être donné pour l'obtention d'un retard de 14T/121. La solution suivante est alors obtenue :

$$p=5,\ q=7,\ n=18,\ k=2.$$

Dans cet exemple, le nombre de cellules peut encore être réduit par la solution ci-dessous :

$$p=5,\ q=14,\ n=9,\ k=1.$$

Neuf cellules sont alors avantageusement suffisantes.

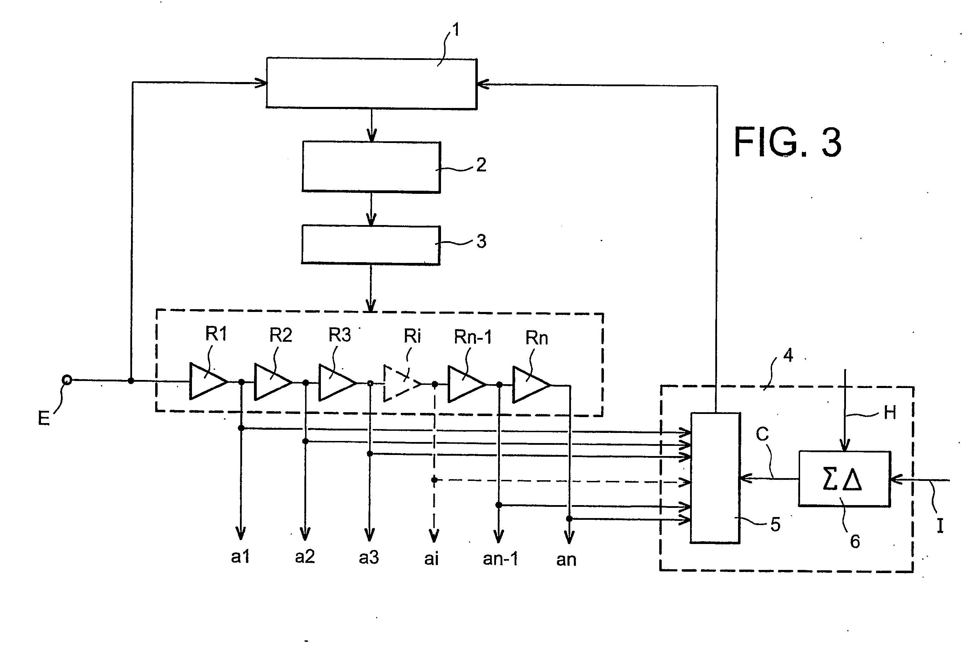

Un exemple de boucle DLL selon le premier mode de réalisation de l'invention va maintenant être décrit en référence à la figure 3.

Selon l'exemple de la figure 3, les moyens de multiplexage 4 comprennent un multiplexeur 5 et un modulateur sigma delta 6. Le modulateur sigma delta 6 comprend une entrée d'horloge et une entrée de signal. Le signal d'horloge H est appliqué sur l'entrée d'horloge et l'information I est appliqué sur l'entrée de signal. Le modulateur sigma delta 6. convertit, au rythme du signal d'horloge H, l'information I en un signal de commande numérique C. Le signal de commande numérique C commande la commutation du multiplexeur 5. Un avantage de l'utilisation d'un modulateur sigma delta est de réduire le bruit de l'information de commande de commutation.

Dans le cas, par exemple, d'une boucle DLL fractionnaire simple, pour générer un séquencement correct des signaux à appliquer au détecteur de phase/fréquence, l'information I appliquée au modulateur sigma delta est égale à une valeur fractionnaire p/q, comme cela a été mentionné précédemment. Le signal C délivré en sortie du modulateur prend deux états différents (un état +1 pour choisir le signal an et un état 0 pour choisir le signal an-1) de telle sorte que la valeur moyenne du signal C soit égale à p/q, à l'erreur de quantification près (une optimisation du modulateur permet cependant de réduire cette erreur de quantification). Il est alors possible d'obtenir un retard moyen de la boucle égal à la quantité (n-p/q)Δt, ce qui est le but recherché.

Une boucle DLL selon le premier mode de réalisation de l'invention n'est bien sûr pas limitée à l'exemple de boucle DLL fractionnaire simple mentionné ci-dessus. De façon plus générale, l'utilisation d'un modulateur sigma delta avec un quantificateur multibit conduit à pouvoir choisir entre les n sorties de retard de la boucle DLL, n étant un nombre supérieur ou égal à 2.

Il est également possible, selon l'invention, d'appliquer une information I variable en entrée du modulateur sigma delta. On obtient alors un retard ou une fréquence modulé par une grandeur variable contenue dans l'information I. Le nombre NC de cellules de retard utilisées est alors une grandeur variable qui module le retard Δt d'une cellule élémentaire. L'invention peut ainsi être mise en oeuvre pour générer un retard variable utilisé pour générer un signal de modulation PPM (PMM pour « Pulse Position Modulation ») utilisé dans en technologie UWB (UWB pour « Ultra Wide Band »).

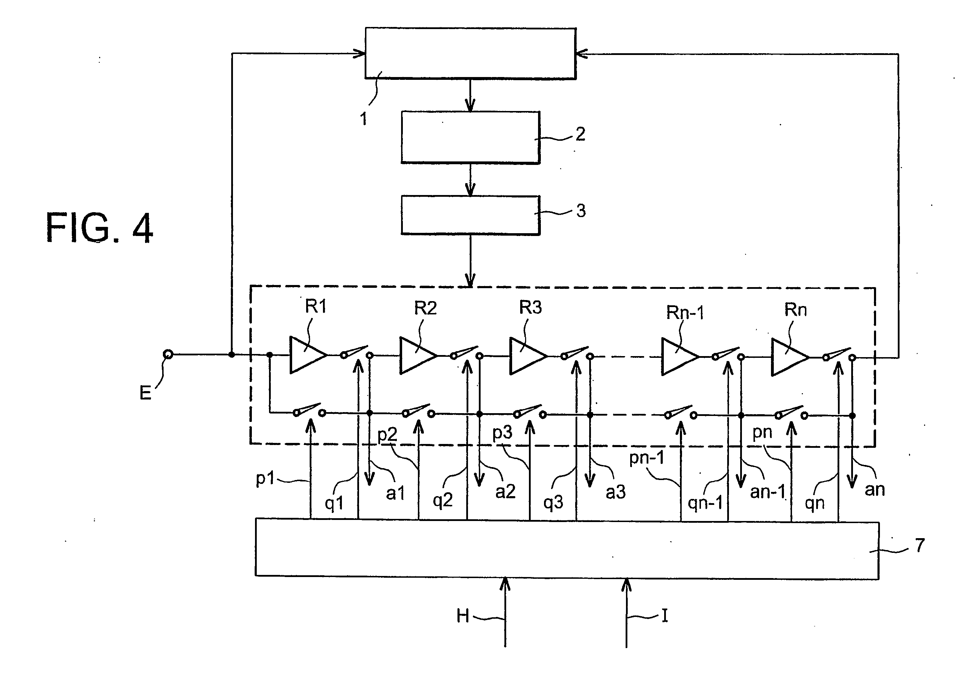

La figure 4 représente un deuxième mode de réalisation de boucle de verrouillage de retard selon l'invention.

Outre les circuits représentés en figure 1, la boucle à verrouillage de retard de la figure 4 comprend un premier ensemble d'interrupteurs Iqi (i=1, 2, ...., n), un deuxième ensemble d'interrupteurs Ipi (i=1, 2, ...., n) et un circuit de commande 7. Chaque interrupteur Ipi est placé en sortie du retard Ri et chaque interrupteur Iqi est placé en parallèle de l'ensemble formé par le retard Ri et l'interrupteur Ipi.

Les interrupteurs Ipi et Iqi sont commandés par les signaux de commande respectifs pi et qi. Le circuit de commande 7 comprend une entrée d'horloge et une entrée de commande sur lesquelles sont respectivement appliqués un signal d'horloge H et un signal de commande I. Les signaux pi et qi sont issus du circuit de commande 7. A chaque coup de l'horloge H, le circuit de commande 7 délivre une combinaison de signaux de commande pi, qi, aptes à ouvrir ou fermer les interrupteurs respectifs Ipi, Iqi. Il est alors possible de retirer un ou plusieurs retards quelconque de la boucle de retards. Si la sortie de la boucle de retard doit osciller, par exemple, entre les signaux an et an-1, il est alors possible de court-circuiter alternativement chacune des cellules de retard suivant un algorithme adapté à cette fin (algorithme aléatoire, algorithme à mise en forme de bruit, etc.). Cela permet avantageusement de réduire l'influence de la dispersion des retards entre chacune des cellules de retard. En effet, par exemple, au cas où la dernière cellule de retard Rn présente un retard sensiblement différent du retard des autres cellules, l'influence de cette cellule sera différente de celles des autres cellules du fait de sa commutation hors boucle.

Une boucle à verrouillage de retard selon le deuxième mode de réalisation de l'invention présente les mêmes avantages qu'une boucle à verrouillage de retard selon le premier mode de réalisation. A titre d'exemple non limitatif, il est ainsi possible de réaliser une boucle DLL fractionnaire simple utilisant deux signaux de retard successifs, par exemple, les signaux an-1 et an. La valeur du retard Δt d'une cellule élémentaire est alors donnée par la relation :

$$\Delta t = q \cdot T / (qn-p),$$

où les grandeurs p, q, n et T sont les grandeurs définies précédemment.

De même, le circuit de commande 7 peut être constitué d'un modulateur sigma delta et d'un circuit de commande numérique (non représentés sur les figures). Les signaux d'horloge H et de commande I sont appliqués sur le modulateur sigma delta et un signal de commande numérique C délivré par le modulateur sigma delta est appliqué au circuit de commande numérique.

Selon un perfectionnement du deuxième mode de réalisation de l'invention, il est possible de rajouter des interrupteurs et des charges commutables en entrée et en sortie des différentes cellules de retard de sorte que, quel que soit le retard programmé, le nombre d'interrupteurs traversés soit toujours le même et que chaque cellule de retard voit toujours la même charge sur son entrée et sur sa sortie.

Dans le cadre d'une réalisation de boucle à verrouillage de retard en technologie sur silicium, et quel que soit le mode de réalisation de l'invention, la précision du retard généré ou de la fréquence synthétisée est fonction de l'appariement qui existe entre les différentes cellules de retard. Le nombre de cellules de retard d'une boucle à verrouillage selon l'invention étant très sensiblement réduit par rapport au nombre de cellules de retard d'une boucle à verrouillage selon l'art antérieur, la contrainte de temps de propagation d'une cellule de retard élémentaire peut être réduite. Il est alors possible d'augmenter la surface des composants utilisés pour réaliser une cellule de retard élémentaire, ce qui a pour effet avantageux d'augmenter la précision de la boucle.

De même, quel que soit son mode de réalisation, une boucle à verrouillage de retard selon l'invention permet avantageusement de générer des retards qui ne sont pas des multiples entiers du délai minimum Tmin tout en travaillant à la fréquence maximale d'utilisation.

D'une façon générale, le grand nombre de degrés de liberté d'une boucle DLL selon l'invention comparativement au nombre de degrés de liberté d'une boucle DLL. selon l'art antérieur permet d'étendre et d'améliorer très sensiblement les performances de la boucle.

L'invention est avantageusement réalisée si elle utilise les techniques classiques d'intégration VLSI sur silicium.

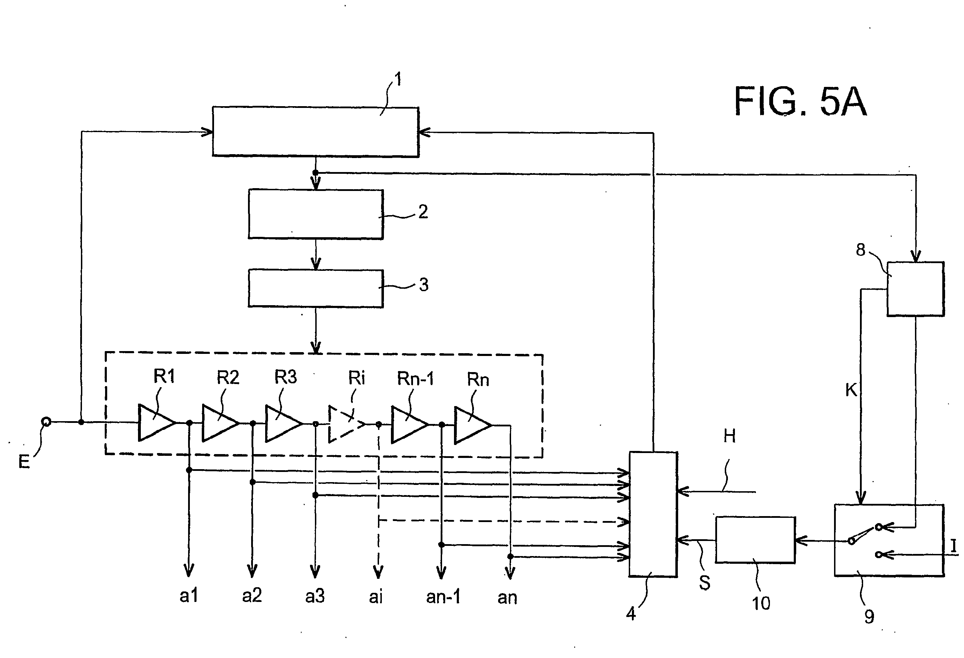

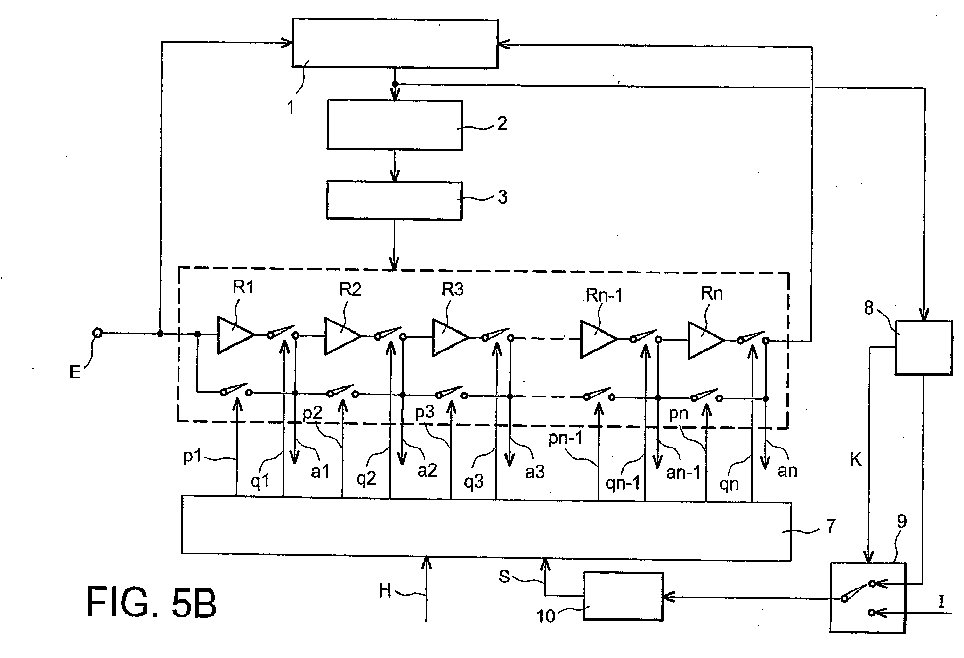

La figure 5A et 5B représentent un perfectionnement de la boucle à verrouillage de retard selon, respectivement, le premier mode de réalisation de l'invention et le deuxième mode de réalisation de l'invention.

Le fonctionnement d'une boucle à verrouillage de retard comprend deux phases distinctes : une phase d'accrochage et une phase durant laquelle le délai élémentaire ne varie plus.

Le retard généré par chacune des cellules de la boucle de retard a une limite inférieure et une limite supérieure. Lors de la phase d'accrochage, un problème de convergence peut alors apparaître, particulièrement lorsque les contraintes d'accrochage sont sévères. Ce problème de convergence peut également apparaître du fait de la grande dispersion des délais élémentaires des différentes cellules lorsque la boucle à verrouillage de retard est réalisée en technologie sur silicium. Lors de la phase d'accrochage, une boucle à verrouillage de retard peut alors se trouver dans un état de blocage lorsque le retard minimum de chaque cellule est atteint et que le retard global est encore trop élevé. La boucle à verrouillage de retard selon le perfectionnement de l'invention représenté aux figures 5A et 5B permet de supprimer cet inconvénient.

Selon le perfectionnement de l'invention, la boucle à verrouillage de retard comprend, en plus des éléments précédemment décrits, un dispositif d'analyse de convergence 8, un commutateur 9 et un circuit de traitement 10. L'entrée du dispositif d'analyse de convergence 8 est reliée à la sortie du détecteur de phase/fréquence 1. Le commutateur 9 comprend deux entrées de signal, une entrée de commande et une sortie. Une première entrée de signal du commutateur 9 est reliée à la sortie du dispositif d'analyse de convergence 8 alors que l'information I mentionnée précédemment est appliquée sur la deuxième entrée de signal. La sortie du commutateur 9 est reliée à l'entrée du circuit de traitement 10 dont la sortie est reliée à l'entrée de commande des moyens de multiplexage 4 (cas de la figure 5A) ou à l'entrée de commande du circuit de commande 7 (cas de la figure 5B).

Le dispositif d'analyse de convergence 8 délivre sur sa sortie une information qui mesure l'état de stabilité et de convergence de la boucle. Le dispositif d'analyse de convergence 8 délivre également le signal de commande du commutateur 9.

Durant la phase d'accrochage, le commutateur 9 est commandé de sorte que la sortie du dispositif d'analyse de convergence 8 soit reliée, via le circuit de traitement 10, à l'entrée de commande des moyens de multiplexage 4 (cas de la figure 5A) ou à l'entrée de commande du circuit de commande 7 (cas de la figure 5B). Le circuit de traitement 10 utilise les informations de convergence issues du dispositif 8 pour indiquer aux moyens de multiplexage 4 ou au circuit de commande 7 s'il doit augmenter ou diminuer le nombre de cellules dans la boucle. Le signal. S issu du circuit de traitement 10 constitue alors une commande permettant de sélectionner un nombre de cellules de retard apte à éviter le blocage de la boucle.

Lorsque la phase d'accrochage est terminée, le commutateur 9 est commandé de sorte que l'entrée du circuit de traitement 10 soit reliée à l'information I précédemment mentionnée. L'information I est alors traitée par le circuit 10 en fonction du nombre de cellules de retard sélectionné pendant la phase d'accrochage. Le circuit de traitement 10 aura donc auparavant mémorisé le nombre de cellules sélectionnées pour obtenir la convergence. Le signal S appliqué sur l'entrée de commande des moyens de multiplexage 4 (cas de la figure 5A) ou sur l'entrée de commande du circuit de commande 7 (cas de la figure 5B) est alors obtenu à partir de l'information I et du nombre de cellules mémorisées.

## Revendications

1. Boucle à verrouillage de retard fractionnaire dans laquelle :

    - une chaîne de cellules de retard (R1, R2, ......, Rn) montées en série a une entrée agencée pour recevoir un signal d'entrée ;
    - un détecteur de phase/fréquence (1) a une première entrée connectée à ladite entrée de la chaîne de cellules de retard, une deuxième entrée connectée sélectivement à la sortie de l'une des cellules de retard, et une sortie couplée à ladite chaîne de cellules de retard pour contrôler le retard de la chaîne de cellules de retard ;
    - la boucle à verrouillage de retard est agencée pour délivrer un signal de retard fractionnaire prélevé sur la sortie de l'une des cellules de retard ; et
    - des moyens de commande (4, 7) sont agencés pour sélectionner, au rythme d'un signal d'horloge (H) et sous l'action d'une information de commande (I), la sortie de la cellule de retard qui est connectée à la deuxième entrée du détecteur phase/fréquence (1).

2. Boucle à verrouillage de retard selon la revendication 1, **caractérisée en ce que** les moyens de commande comprennent des moyens de multiplexage (4) ayant n entrées et une sortie, chaque entrée des moyens de multiplexage (4) étant reliée à une sortie de cellule de retard différente, la sortie des moyens de multiplexage étant reliée à la deuxième entrée du détecteur phase/fréquence.

3. Boucle à verrouillage de phase selon la revendication 2, **caractérisée en ce que** les moyens de multiplexage (4) comprennent un multiplexeur (5) et un modulateur sigma delta (6) ayant une entrée d'horloge sur laquelle est appliqué le signal d'horloge (H) et une entrée de signal sur laquelle est appliquée l'information de commande (I), le modulateur sigma delta (6) délivrant un signal de commande numérique appliqué au multiplexeur (5).

4. Boucle à verrouillage de retard selon la revendication 1, **caractérisée en ce que** les moyens de commande comprennent un premier ensemble d'interrupteurs Iqi (i=1, 2, ..., n), un deuxième ensemble d'interrupteurs Ipi (i=1, 2, ...., n) et un circuit de commande (7) ayant une entrée d'horloge sur laquelle est appliqué le signal d'horloge (H) et une entrée de commande sur laquelle est appliquée l'information de commande (I), l'interrupteur Ipi étant placé en sortie de la cellule de retard Ri de rang i et l'interrupteur Iqi étant placé en parallèle de l'ensemble formé par la cellule de retard Ri de rang i et par l'interrupteur Ipi, les interrupteurs Ipi et Iqi étant commandés par des signaux de commande respectifs pi et qi issus du circuit de commande (7).

5. Boucle à verrouillage de retard selon la revendication 4, **caractérisée en ce que** des interrupteurs et des charges commutables sont placées en entrée et en sortie des différentes cellules de retard (R1, R2, ......, Rn) de sorte que, lors du fonctionnement de la boucle, le nombre total d'interrupteurs utilisés dans la boucle soit constant et que chaque cellule de retard voit toujours la même charge sur son entrée et sur sa sortie.

6. Boucle à verrouillage de retard selon l'une quelconque des revendications 4 ou 5, **caractérisée en ce que** le circuit de commande (7) comprend un modulateur sigma delta ayant une entrée d'horloge sur laquelle est appliquée le signal d'horloge (H) et une entrée de signal sur laquelle est appliquée le signal de commande (I) et un circuit de commande numérique sur lequel est appliqué un signal de commande numérique délivré par le modulateur sigma delta.

7. Boucle à verrouillage de retard selon l'une quelconque des revendications précédentes, **caractérisée en ce que** l'information de commande (I) est une valeur fractionnaire p/q de sorte que la sortie de la chaîne de retard est constituée par la sortie de la cellule de retard de rang n-1 pendant p coups d'horloge et par la sortie de la cellule de retard de rang n pendant q coups d'horloge, p et q étant deux nombres entiers, q étant supérieur à p, et que la valeur du retard d'une cellule de retard est donnée par la formule :

$$\Delta t = q\ T/(qn-p),$$

où

T est la période d'un signal appliqué en entrée de la chaîne de retard.

8. Boucle à verrouillage de retard selon l'une quelconque des revendications précédentes, **caractérisée en ce que** le signal d'horloge (H) est, à un retard près, identique à un signal appliqué sur la première entrée du détecteur de phase/fréquence (1).

9. Boucle à verrouillage de retard selon l'une quelconque des revendications 1 à 7, **caractérisée en ce que** le signal d'horloge (H) est un signal dont la période est inférieure à la période du signal appliqué sur la première entrée du détecteur de phase/fréquence (1).

10. Boucle à verrouillage de retard selon l'une quelconque des revendications 1 à 9, **caractérisée en ce qu'**elle comprend des moyens (8, 9, 10) pour sélectionner, pendant une phase d'accrochage de la boucle, un nombre de cellules de retard apte à éviter un blocage de la boucle.

11. Boucle à verrouillage de retard selon la revendication 10, **caractérisée en ce que** les moyens (8, 9, 10) pour sélectionner, pendant une phase d'accrochage de la boucle, le nombre de cellules de retard apte à éviter un blocage de la boucle comprennent un dispositif d'analyse de convergence 8, un commutateur (9) et un circuit de traitement (10), l'entrée du dispositif d'analyse de convergence (8) étant reliée à la sortie du détecteur de phase/fréquence (1), le commutateur (9) étant commandé de façon à relier la sortie du dispositif de convergence (8) à l'entrée du circuit de traitement (10), la sortie du circuit de traitement (10) étant reliée à une entrée de commande des moyens de commande (4, 7).

12. Boucle à verrouillage de retard selon la revendication 10 ou 11, **caractérisée en ce qu'**elle comprend des moyens (10) pour mémoriser le nombre de cellules de retard sélectionné.

**Claims**

1. A fractional delay locked loop wherein:

   - a line of delay cells (R1, R2, ..., Rn) mounted in series has an input arranged to receive an input signal;
   - a phase/frequency detector (1) has a first input connected to said input of the line of delay cells, a second input selectively connected to the output of one of the delay cells and an output coupled with said line of delay cells to control the delay of the line of delay cells;
   - the delay locked loop is arranged to output a fractional delay taken from the output of one of the delay cells; and

- control means (4, 7) are arranged to select, at the rate of a clock signal (H) and due to control information (I), the output of the delay cell which is connected to the second input of the phase/ frequency detector (1).

2. Delay locked loop according to claim 1, **characterised in that** the control means comprise multiplexing means (4) with n inputs and one output, each input of the multiplexing means (4) being connected to one different delay cell output, the output from the multiplexing means being connected to the second input of the phase/frequency detector.

3. Phased locked loop according to claim 2, **characterised in that** the multiplexing means (4) comprise a multiplexer (5) and a sigma delta modulator (6) with a clock input on which said clock signal (H) is applied and a signal input on which said control information (I) is applied, the sigma delta modulator (6) outputting a digital control signal applied to the multiplexer (5).

4. Delay locked loop according to claim 1, **characterised in that** the control means comprise a first set of switches Iqi (i = 1, 2, ..., n), a second set of switches Ipi (i = 1, 2, ..., n) and a control circuit (7) with a clock input on which said clock signal (H) is applied and a control input on which said control information (I) is applied, the switch Ipi being placed at the output from the rank i delay cell Ri and the switch Iqi being placed in parallel with the assembly formed by the rank i delay cell Ri and the switch Ipi, switches Ipi and Iqi being controlled by control signals pi and qi respectively output from the control circuit (7).

5. Delay locked loop according to claim 4, **characterised in that** switches and switchable loads are placed at the input and output of the different delay cells (R1, R2, ..., Rn) such that the total number of switches used in the loop during operation of the loop is always the same, and each delay cell always sees the same load on its input and on its output.

6. Delay locked loop according to either claim 4 or 5, **characterised in that** the control circuit (7) comprises a sigma delta modulator with a clock input on which said clock signal (H) is applied and a signal input on which said control signal (I) is applied and a digital control circuit on which a digital control signal output by the sigma delta modulator is applied.

7. Delay locked loop according to any one of the above claims, **characterised in that** the control information (I) is a fractional value p/q such that the output from the delay line is composed of the output from the rank n-1 delay line for p clock ticks and the output from the rank n delay line during q clock ticks, where p and q are two integer numbers and q is greater than p, and the value of the delay of a delay cell is given by the relation:

$$\Delta t = q\, T/(qn-p),$$

where T is the period of a signal applied to the input of the delay line.

8. Delay locked loop according to any one of the above claims, **characterised in that** the clock signal (H) is identical to a signal applied to the first input of the phase/frequency detector (1), except for a delay.

9. Delay locked loop according to any one of claims 1 to 7, **characterised in that** the clock signal (H) is a signal with a period less than the period of the signal applied to the first input of the phase/frequency detector (1).

10. Delay locked loop according to any one of claims 1 to 9, **characterised in that** it comprises means (8, 9, 10) to select a number of delay cells such that the loop will not get locked, during a loop latching phase.

11. Delay locked loop according to claim 10, **characterised in that** the means (8, 9, 10) provided to select the number of delay cells to prevent the loop from getting locked, during a loop latching phase, comprise a convergence analysis device (8), a switch (9) and a processing circuit (10), the input to the convergence analysis device (8) being connected to the output from the phase/frequency detector (1), the switch (9) being controlled such that the output from the convergence device (8) is connected to the input to the processing circuit (10), the output from the processing circuit (10) being connected to a control input of the control means (4, 7).

12. Delay locked loop according to either claim 10 or 11, **characterised in that** it comprises means (10) of memorising the selected number of delay cells.

**Patentansprüche**

1. Verriegelte Schleife mit fraktionärer Verzögerung, in welcher

- eine Kette von in Reihe geschalteten Verzögerungszellen (R1, R2,.... ...... Rn) einen Eingang zum Empfang eines Eingangssignals aufweist;
- ein Phasen / Frequenzdetektor (1) einen mit dem genannten Eingang der Kette von Verzögerungszelien verbundenen ersten Eingang aufweist, einen selektiv mit dem Ausgang einer der Verzögerungszellen verbundenen zweiten Eingang, sowie einen mit der genannten Kette von Verzögerungszellen gekoppelten Ausgang zur Steuerung der Verzögerung der Kette von Verzögerungszellen;

- die verriegelte Verzögerungsschleife so ausgebildet und betätigbar ist, dass sie ein am Ausgang einer der Verzögerungszellen abnehmbares fraktionäres Verzögerungssignal liefert;

- Befehismittel (4, 7) so ausgebildet und angeordnet sind, dass sie, im Rhythmus eines Taktsignals (H) und unter der Winkung einer Befehlsinformation (I) den Ausgang der Verzögerungszelle auswählen, die mit dem zweiten Eingang des Phasen / Frequenzdetektors (1) verbunden ist.

2. Verriegelte Verzögerungsschleife nach Anspruch 1, **dadurch gekennzeichnet, dass** die Befehlsmittel Multiplex-Mittel (4) mit n Eingängen und einem Ausgang umfassen, dass jeweils jeder Eingang der Multiplexmittel (4) mit einem Ausgang einer unterschiedlichen Verzögerungszelle verbunden ist, und daß der Ausgang der Multiplexmittel mit dem zweiten Eingang des Phasen / Frequenzdetektors verbunden ist.

3. Phasenverriegelte Schleife nach Anspruch 2, **dadurch gekennzeichnet, dass** die Multiplexmittel (4) einen Multiplexer (5) und einen Sigma-Delta-Modulator (6) aufweisen, dass der Sigma / Delta-Modulator einen Takteingang, an welchem das Taktsignal (H) zugeführt wird, und einen Signaleingang, aufweist, an welchem die Befehlsinformation (I) zugeführt wird, und dass der Sigma-Delta-Madulator (6) ein dem Multiplexer (5) zugeführtes digitales Befehlssignal liefert.

4. Verriegelte Verzögerungsschleife nach Anspruch 1, **dadurch gekennzeichnet, dass** die Befehlsmittel eine erste Gruppe von Unterbrecherschaltern lqi (i = 1, 2, ..., n), eine zweite Gruppe von Unterbrecher schaltern lpi (i = 1, 2, ....., n), und eine Befehtsschaltung (7) umfassen, weiche einen Takteingang aufweist, an welchem das Taktsignal (H) zugeführt wird, und einen Befehlseingang (I), an welchem die Befehlsinformation (I) zugeführt wird, dass der Schalter lpi im Ausgang der Verzögerungszelle Ri vom Rang i und der Schalter lqi parallel zu dem Gebilde aus der Verzögerungszelle Ri vom Rang i und dem Schalter lpi angeordnet ist, und wobei die Schalter lpi und lqi durch aus der Befehlsschaltung (7) hervorgehende Befehlssignale gesteuert werden.

5. Verriegelte Verzögerungsschleife nach Anspruch 4, **dadurch gekennzeichnet, dass** Schalter und umschaltbare Verbraucherlasten im Eingang und im Ausgang der verschiedenen Verzögerungszellen (R1, R2 ,......, Rn) angeordnet werden derart dass im Betriebszustand der Schleife die Gesamtzahl der in der Schleife verwendeten Schalter konstant ist und dass jeweils jede Verzögerungszelle jeweils dieselbe Last in ihrem Eingang und in ihrem Ausgang sieht.

6. Verriegelte Verzögerungsschleife nach einem der Ansprüche 4 oder 5, **dadurch gekennzeichnet, dass** die Befehisschaltung (7) einen Sigma-Delta-Modulator mit einem Takteingang, dem das Taktsignal (H) zugeführt wird, und mit einem Signaleingang, an welchem das Befehlssignal (I) angelegt wird, sowie eine digitale Befehlsschaltung aufweist, welcher ein von dem Sigma-Delta-Modulator geliefertes digitales Befehlssignal zugeführt wird.

7. Verriegelbare Verzögerungsschleife nach einem der vor-hergehenden Ansprüche, **dadurch gekennzeichnet, dass** die Befehlsinformation (I) ein Bruchteilwert p/q ist derart dass der Ausgang der Verzögerungskette während p aktimpulsen durch den Ausgang der Verzögrungszelle vom Rang n - 1 und während q Taktimpulsen durch den Ausgang der Verzögerungszelle vom Rang n gebildet wird, wobei p und qzwei ganze Zahlen sind und q größer als p ist, und dass der Betrag der Verzögerung einer Verzögerungszelle gegeben ist durch die Formel.

$$\Delta t = q\,T\,/\,(qn - p), \text{ wobei}$$

T die Periode eines am Eingang der Verzögerungskette zugeführten Signals ist.

8. Verriegelte Verzögerungsschleife nach einem der vorhergehenden Ansprüche, **dadurch gekennzeichnet, dass** das Taktsignal (H) bis auf eine Verzögerung mit einem dem ersten Eingang des Phasen / Frequenz-Detektors (1) übereinstimmt.

9. Verriegelte Verzögerungsschleife nach einem der Ansprüche 1 bis 7, **dadurch gekennzeichnet , dass** das Taktsignal (H) ein Signal ist, dessen Periode kleiner als die Periode des am ersten Eingang des Phasen / Frequenz -Detektors (1) zugeführten Signals ist.

10. Verriegelte Verzögerungsschleife nach einem der Ansprüche 1 bis 9, **dadurch gekennzeichnet, dass** sie Mittel (8, 9, 10) aufweist, um - während einer Einfang- bzw. Einkuppelphase der Schleife - eine zur Vermeidung einer Blockierung der Schleife geeignete Anzahl von Verzögerungszellen auszuwählen.

11. Verriegelte Verzögerungsschleife nach Anspruch 10, **dadurch gekennzeichnet, dass** die Mittel (8, 9, 10) um - während einer Einfang - bzw. Einkuppelphase der Schleife

> - die zur Vermeidung einer Blockierung der Schleife geeignete Anzahl von Verzögerungszeflen auszuwählen eine Konvergenzanalyse-Vorrichtung (8), einen Kommutator bzw. Umschalter (9) sowie eine Bearbeitungsschaltung (19) aufweisen, wobei der Eingang der Konvergenzanalyse-Vorrichtung (8) mit dem Ausgang des Phasen/Frequenz-Detektors (1) verbunden ist und der Kommutator (9) so gesteuert wird, dass der Ausgang der Konvergenzanalyse-Vorrichtung (8) mit dem Eingang der Verarbeitungsschaltung (10) verbunden wird, und wobei der Ausgang der Verarbeitungsschaltung (10) mit einem Befehlseingang der Befehlsmittel (4, 7) verbunden ist.

12. Verriegelte Verzögerungsschleife nach Anspruch 10 oder nach Anspruch 11, **dadurch gekennzeichnet dass** sie Mittel (10) zum Speichern der Anzahl ausgewählter Verzögerungszellen umfasst.

FIG. 1

FIG. 2

FIG. 3

EP 1 514 352 B1

FIG. 4

EP 1 514 352 B1

FIG. 5A

FIG. 5B

EP 1 514 352 B1

EP 1 514 352 B1

## RÉFÉRENCES CITÉES DANS LA DESCRIPTION

**Documents brevets cités dans la description**

- US 6147525 A

- WO 0145263 A

**Littérature non-brevet citée dans la description**

- An Eight Channel 36GSample/s CMOS Timing Analyser. **Dan Weinlader ; Ron Ho ; Chih-Kong Ken Yang ; Mark Horowitz.** IEEE International Solid-State Circuits Conference. 2000